(19) Europäisches Patentamt
European Patent Office
Office européen des brevets

(11) **EP 4 155 822 A1**

(12) **EUROPEAN PATENT APPLICATION**

(43) Date of publication:
**29.03.2023 Bulletin 2023/13**

(21) Application number: **21199332.4**

(22) Date of filing: **28.09.2021**

(51) International Patent Classification (IPC):
**G03F 7/20** (2006.01)       **G03F 9/00** (2006.01)

(52) Cooperative Patent Classification (CPC):
**G03F 7/705; G03F 7/70616; G03F 7/70633;**
**G03F 7/70641; G03F 9/7019; G03F 9/7092**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **HUISMAN, Simon, Reinald**
 **5500 AH Veldhoven (NL)**
• **GOORDEN, Sebastianus, Adrianus**
 **5500 AH Veldhoven (NL)**
• **BELT, Harm, Jan, Willem**
 **5500 AH Veldhoven (NL)**

(74) Representative: **ASML Netherlands B.V.**
 **Corporate Intellectual Property**
 **P.O. Box 324**
 **5500 AH Veldhoven (NL)**

Remarks:
Claims 16 to 57 are deemed to be abandoned due to non-payment of the claims fees (Rule 45(3) EPC).

(54) **METROLOGY METHOD AND SYSTEM AND LITHOGRAPHIC SYSTEM**

(57)    Disclosed is a method for measuring a parameter of interest from a target and associated apparatuses. The method comprises obtaining measurement acquisition data relating to measurement of a target on a production substrate during a manufacturing phase; obtaining a calibration correction database and/or a trained model having been trained on said calibration correction database, operable to correct for effects in the measurement acquisition data; correcting for effects in the measurement acquisition data using first correction data from said calibration correction database and/or using said trained model so as to obtain corrected measurement data and/or a corrected parameter of interest which is/are corrected for at least said effects; and updating said calibration correction data and/or said trained model with said corrected measurement data and/or corrected parameter of interest.

Fig. 17

**Description**

FIELD OF INVENTION

The present invention relates to methods and apparatus usable, for example, in the manufacture of devices by lithographic techniques, and to methods of manufacturing devices using lithographic techniques. The invention relates more particularly to metrology sensors, such as position sensors.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, it is often desirable to be able to measure on increasingly smaller targets. However, measurements on such small targets are subject to finite-size effects, leading to measurement errors.

It is desirable to improve measurements on such small targets.

SUMMARY OF THE INVENTION

The invention in a first aspect provides a method for measuring a parameter of interest, comprising: obtaining measurement acquisition data relating to measurement of a target on a production substrate during a manufacturing phase; obtaining a calibration correction database and/or a trained model having been trained on said calibration correction database, operable to correct for effects in the measurement acquisition data; correcting for effects in the measurement acquisition data using first correction data from said calibration correction database and/or using said trained model so as to obtain corrected measurement data and/or a corrected parameter of interest which is/are corrected for at least said effects; and updating said calibration correction data and/or said trained model with said corrected measurement data and/or corrected parameter of interest.

Also disclosed is a computer program, processing device metrology apparatus and a lithographic apparatus comprising a metrology device being operable to perform the method of the first aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 is a schematic illustration of an example metrology device adaptable according to an embodiment of the invention;
Figure 4 comprises (a) a pupil image of input radiation (b) pupil image of off-axis illumination beams illustrating an operational principle of the metrology device of Figure 3; and (c) pupil image of off-axis illumination beams illustrating another operational principle of the metrology device of Figure 3;
and
Figure 5 shows (a) an example target usable in alignment, (b) a pupil image of the detection pupil corresponding to detection of a single order, (c) a pupil image of the detection pupil corresponding to detection of four diffraction orders, and (d) a schematic example of an imaged interference pattern following measurement of the target of Figure 4(a);
Figure 6 shows schematically during an alignment measurement, an imaged interference pattern corresponding to (a) a first substrate position and (b) a second substrate position;
Figure 7 is a flow diagram of a known baseline fitting algorithm for obtaining a position measurement from a measurement image;
Figure 8 is a flow diagram describing a method for determining a parameter of interest;
Figure 9 is a flow diagram describing a step of the method of Figure 8 which corrects for finite-size effects in a measurement image;
Figure 10 is a flow diagram describing a first method of extracting local phase by performing a spatially weighted fit;
Figure 11 is a flow diagram describing a second method of extracting local phase based on quadrature detection;
Figure 12 is a flow diagram describing a pattern recognition method to obtain global quantities from a measurement signal;
Figure 13 is a flow diagram describing a method for determining a parameter of interest based on a single mark calibration;
Figure 14 is a flow diagram describing a method for determining a parameter of interest based on a correction library;
Figure 15 is a flow diagram describing a method for determining a parameter of interest based on application of a trained model;
Figure 16 is a flow diagram describing a method for determining a parameter of interest based on separate calibrations for mark specific and non-mark specific effects; and
Figure 17 is a flow diagram describing a method for updating a correction library with inline HVM data according to an embodiment of the invention.

DETAILED DESCRIPTION OF EMBODIMENTS

Before describing embodiments of the invention in detail, it is instructive to present an example environment in which embodiments of the present invention may be implemented.

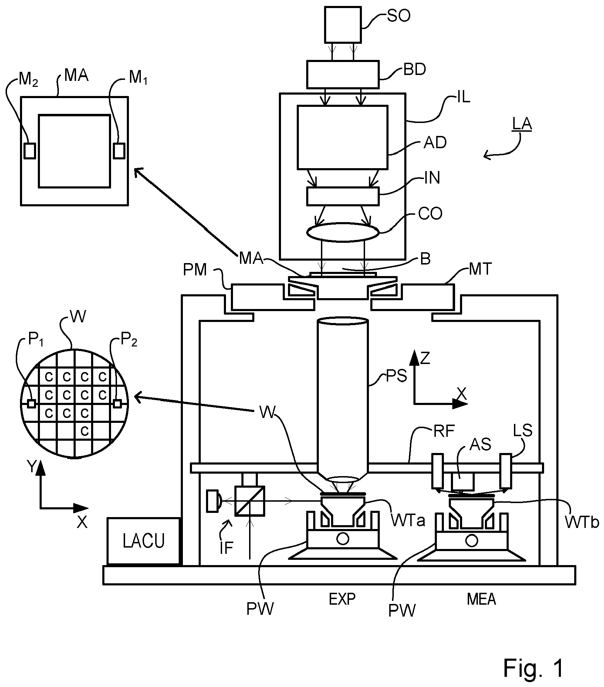

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

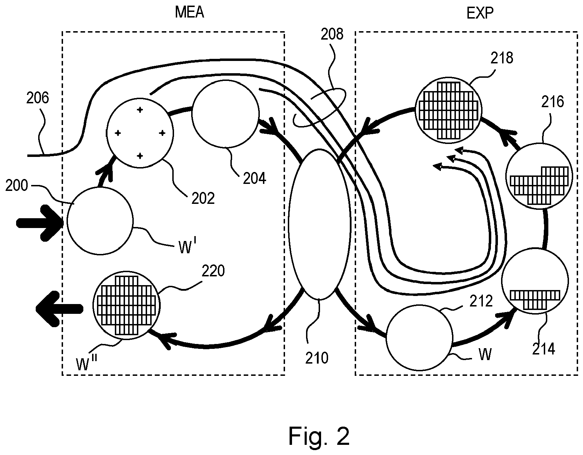

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

A specific type of metrology sensor, which as both alignment and product/process monitoring metrology applications is described in PCT patent application WO 2020/057900 A1, which is incorporated herein by reference. This describes a metrology device with optimized coherence. More specifically, the metrology device is configured to produce a plurality of spatially incoherent beams of measurement illumination, each of said beams (or both beams of measurement pairs of said beams, each measurement pair corresponding to a measurement direction) having corresponding regions within their cross-section for which the phase relationship between the beams at these regions is known; i.e., there is mutual spatial coherence for the corresponding regions.

Such a metrology device is able to measure small pitch targets with acceptable (minimal) interference artifacts (speckle) and will also be operable in a dark-field mode. Such a metrology device may be used as a position or alignment sensor for measuring substrate position (e.g., measuring the position of a periodic structure or alignment mark with respect to a fixed reference position). However, the metrology device is also usable for measurement of overlay (e.g., measurement of relative position of periodic structures in different layers, or even the same layer in the case of stitching marks). The metrology device is also able to measure asymmetry in periodic structures, and therefore could be used to measure any parameter which is based on a target asymmetry measurement (e.g., overlay using diffraction based overlay (DBO) techniques or focus using diffraction based focus (DBF) techniques).

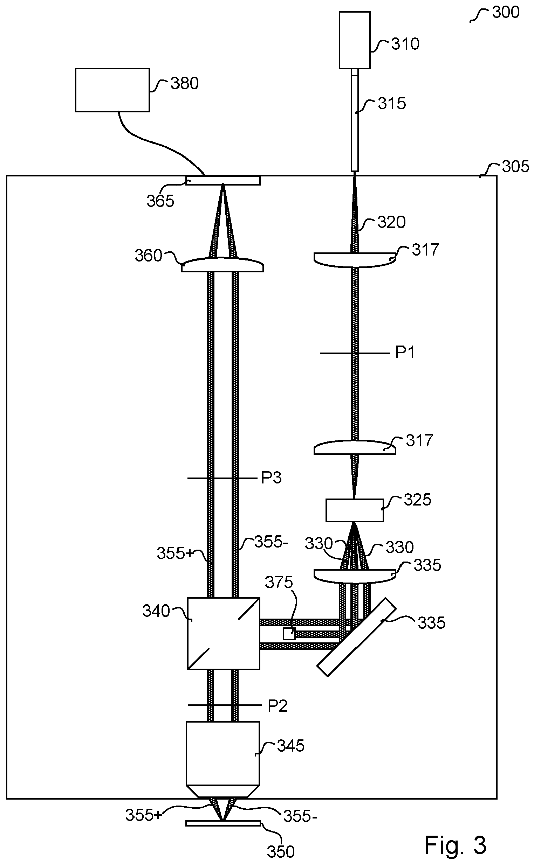

Figure 3 shows a possible implementation of such a metrology device. The metrology device essentially operates as a standard microscope with a novel illumination mode. The metrology device 300 comprises an optical module 305 comprising the main components of the device. An illumination source 310 (which may be located outside the module 305 and optically coupled thereto by a multimode fiber 315) provides a spatially incoherent radiation beam 320 to the optical module 305. Optical components 317 deliver the spatially incoherent radiation beam 320 to a coherent off-axis illumination generator 325. This component is of particular importance to the concepts herein and will be described in greater detail. The coherent off-axis illumination generator 325 generates a plurality (e.g., four) off-axis beams 330 from the spatially incoherent radiation beam 320. The characteristics of these off-axis beams 330 will be described in detail further below. The zeroth order of the illumination generator may be blocked by an illumination zero order block element 375. This zeroth order will only be present for some of the coherent off-axis illumination generator examples described in this document (e.g., phase grating based illumination generators), and therefore may be omitted when such zeroth order illumination is not generated. The off-axis beams 330 are delivered (via optical components 335 and) a spot mirror 340 to an (e.g., high NA) objective lens 345. The objective lens focusses the off-axis beams 330 onto a sample (e.g., periodic structure/alignment mark) located on a substrate 350, where they scatter and diffract. The scattered higher diffraction orders 355+, 355- (e.g., +1 and -1 orders respectively), propagate back via the spot mirror 340, and are focused by optical component 360 onto a sensor or camera 365 where they interfere to form an interference pattern. A processor 380 running suitable software can then process the image(s) of the interference pattern captured by camera 365.

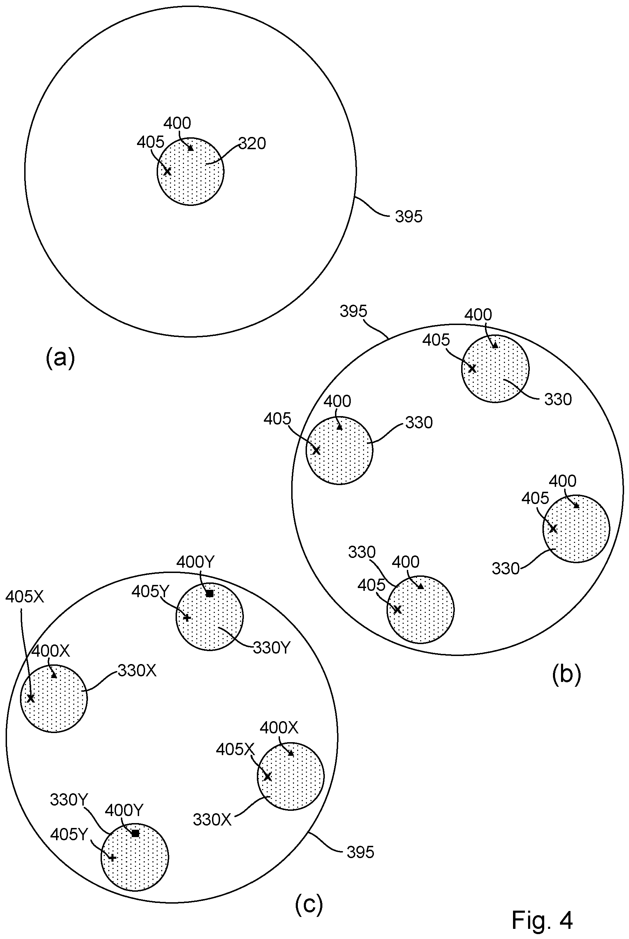

The zeroth order diffracted (specularly reflected) radiation is blocked at a suitable location in the detection branch; e.g., by the spot mirror 340 and/or a separate detection zero-order block element. It should be noted that there is a zeroth order reflection for each of the off-axis illumination beams, i.e. in the current embodiment there are four of these zeroth order reflections in total. An example aperture profile suitable for blocking the four zeroth order reflections is shown in Figures 4(b) and (c), labelled 422. As such, the metrology device operated as a "dark field" metrology device.

A main concept of the proposed metrology device is to induce spatial coherence in the measurement illumination only where required. More specifically, spatial coherence is induced between corresponding sets of pupil points in each of the off-axis beams 330. More specifically, a set of pupil points comprises a corresponding single pupil point in each of the off-axis beams, the set of pupil points being mutually spatially coherent, but where each pupil point is incoherent with respect to all other pupil points in the same beam. By optimizing the coherence of the measurement illumination in this manner, it becomes feasible to perform dark-field off-axis illumination on small pitch targets, but with minimal speckle artifacts as each off-axis beam 330 is spatially incoherent.

Figure 4 shows three pupil images to illustrate the concept. Figure 4(a) shows a first pupil image which relates to pupil plane P1 in Figure 3, and Figures 4(b) and 4(c) each show a second pupil image which relates to pupil plane P2 in Figure 3. Figure 4(a) shows (in cross-section) the spatially incoherent radiation beam 320, and Figures 4(b) and 4(c) show (in cross-section) the off-axis beams 330 generated by coherent off-axis illumination generator 325 in two different embodiments. In each case, the extent of the outer circle 395 corresponds to the maximum detection NA of the microscope objective; this may be, purely by way of an example 0.95 NA.

The triangles 400 in each of the pupils indicate a set of pupil points that are spatially coherent with respect to each other. Similarly, the crosses 405 indicate another set of pupil points which are spatially coherent with respect to each other. The triangles are spatially incoherent with respect to crosses and all other pupil points corresponding to beam propagation. The general principle (in the example shown in Figure 4(b)) is that each set of pupil points which are mutually spatially coherent (each coherent set of points) have identical spacings within the illumination pupil P2 as all other coherent sets of points. As such, in this embodiment, each coherent sets of points is a translation within the pupil of all other coherent sets of points.

In Figure 4(b), the spacing between each pupil point of the first coherent set of points represented by triangles 400 must be equal to the spacing between each pupil point of the coherent set of points represented by crosses 405. 'Spacing' in this context is directional, i.e., the set of crosses (second set of points) is not allowed to be rotated with respect to the set of triangles (first set of points). As such, each of the off-axis beams 330 comprises by itself incoherent radiation; however the off-axis beams 330 together comprise identical beams having corresponding sets of points within their cross-section that have a known phase relationship (spatial coherence). It should be noted that it is not necessary for the points of each set of points to be equally spaced (e.g., the spacing between the four triangles 405 in this example is not required to be equal). As such, the off-axis beams 330 do not have to be arranged symmetrically within the pupil.

Figure 4(c) shows that this basic concept can be extended to providing for a mutual spatial coherence between only the beams corresponding to a single measurement direction where beams 330X correspond to a first direction (X-direction) and beams 330Y correspond to a second direction (Y-direction). In this example, the squares and plus signs each indicate a set of pupil points which correspond to, but are not necessarily spatially coherent with, the sets of pupil points represented by the triangles and crosses. However, the crosses are mutually spatially coherent, as are the plus signs, and the crosses are a geometric translation in the pupil of the plus signs. As such, in Figure 4(c), the off-axis beams are only pair-wise coherent.

In this embodiment, the off-axis beams are considered separately by direction, e.g., X direction 330X and Y direction 330Y. The pair of beams 330X which generate the captured X direction diffraction orders need only be coherent with one another (such that pair of points 400X are mutually coherent, as are pair of points 405X). Similarly the pair of beams 330Y which generate the captured Y direction diffraction orders need only be coherent with one another (such that pair of points 400Y are mutually coherent, as are pair of points 405Y). However, there does not need to be coherence between the pairs of points 400X and 400Y, nor between the pairs of points 405X and 405Y. As such there are pairs of coherent points comprised in the pairs of off-axis beams corresponding to each considered measurement direction. As before, for each pair of beams corresponding to a measurement direction, each pair of coherent points is a geometric translation within the pupil of all the other coherent pairs of points.

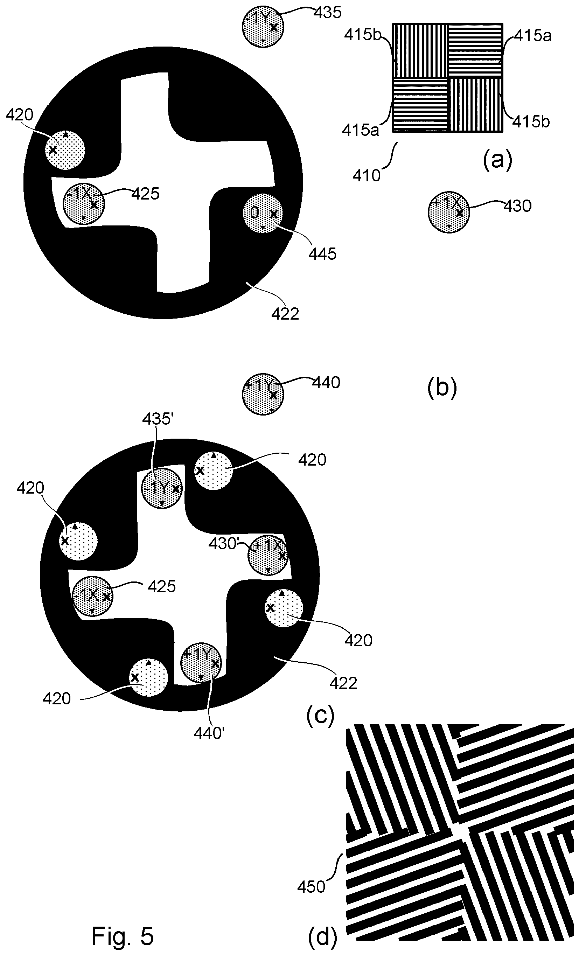

Figure 5 illustrates the working principle of the metrology system, e.g., for alignment/Position sensing. Figure 5(a) illustrates a target 410 which can be used as an alignment mark in some embodiments. The target 410 may be similar to those used in micro diffraction based overlay techniques (μDBO), although typically comprised only in a single layer when forming an alignment mark. As such, the target 410 comprises four sub-targets, comprising two gratings (periodic structures) 415a in a first direction (X-direction) and two gratings 415b in a second, perpendicular, direction (Y-direction). The pitch of the gratings may comprise an order of magnitude of 100nm (more specifically within the range of 300-800nm), for example.

Figure 5(b) shows a pupil representation corresponding to (with reference to Figure 2) pupil plane P3. The Figure shows the resulting radiation following scattering of only a single one of the off-axis illumination beams, more specifically (the left-most in this representation) off-axis illumination beam 420 (which will not be in this pupil, its location in pupil plane P2 corresponds to its location in the illumination pupil and is shown here only for illustration). The shaded region 422 corresponds to the blocking (i.e., reflecting or absorbing) region of a specific spot mirror design (white represents the transmitting region) used in an embodiment. Such a spot mirror design is purely an example of a pupil block which ensures that undesired light (e.g. zeroth orders and light surrounding the zeroth orders) are not detected.

Other spot mirror profiles (or zero order blocks generally) can be used.

As can be seen, only one of the higher diffraction orders is captured, more specifically the -1 X direction diffraction order 425. The +1 X direction diffraction order 430, the -1 Y direction diffraction order 435 and the +1 Y direction diffraction order 440 fall outside of the pupil (detection NA represented by the extent of spot mirror 422) and are not captured. Any higher orders (not illustrated) also fall outside the detection NA. The zeroth order 445 is shown for illustration, but will actually be blocked by the spot mirror or zero order block 422.

Figure 5(c) shows the resultant pupil (captured orders only) resultant from all four off-axis beams 420 (again shown purely for illustration). The captured orders include the -1 X direction diffraction order 425, a +1 X direction diffraction order 430', a -1 Y direction diffraction order 435' and a +1 Y direction diffraction order 440'. These diffraction orders are imaged on the camera where they interfere forming a fringe pattern 450, such as shown in Figure 5(d). In the example shown, the fringe pattern is diagonal as the diffracted orders are diagonally arranged in the pupil, although other arrangements are possible with a resulting different fringe pattern orientation.

In a manner similar to other metrology devices usable for alignment sensing, a shift in the target grating position causes a phase shift between the +1 and -1 diffracted orders per direction. Since the diffraction orders interfere on the camera, a phase shift between the diffracted orders results in a corresponding shift of the interference fringes on the camera. Therefore, it is possible to determine the alignment position from the position of the interference fringes on the camera.

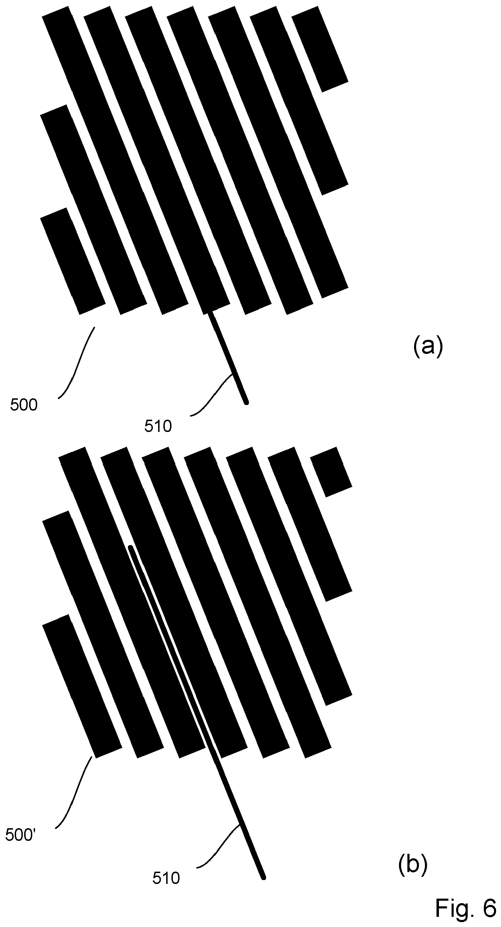

Figure 6 illustrates how the alignment position can be determined from the interference fringes. Figure 6(a) shows one set of interference fringes 500 (i.e., corresponding to one quadrant of the fringe pattern 450), when the target is at a first position and Figure 6(b) the set of interference fringes 500' when the target is at a second position. A fixed reference line 510 (i.e., in the same position for both images) is shown to highlight the movement of the fringe pattern between the two positions. Alignment, can be determined by comparing a position determined from the pattern to a position obtained from measurement of a fixed reference (e.g., transmission image sensor (TIS) fiducial) in a known manner. A single fringe pattern (e.g., from a single grating alignment mark), or single pattern per direction (e.g., from a two grating alignment mark), can be used for alignment. Another option for performing alignment in two directions may use an alignment mark having a single 2D periodic pattern. Also, non-periodic patterns could be measured with the metrology device described herein. Another alignment mark option may comprise a four grating target design, such as illustrated in Figure 5(a), which is similar to that commonly used for measuring overlay, at present. As such, targets such as these are typically already present on wafers, and therefore similar sampling could be used for alignment and overlay. Such alignment methods are known and will not be described further.

WO 2020/057900 further describes the possibility to measure multiple wavelengths (and possibly higher diffraction orders) in order to be more process robust (facilitate measurement diversity). It was proposed that this would enable, for example, use of techniques such as optimal color weighing (OCW), to become robust to grating asymmetry. In particular, target asymmetry typically results in a different aligned position per wavelength. Thereby, by measuring this difference in aligned position for different wavelengths, it is possible to determine asymmetry in the target. In one embodiment, measurements corresponding to multiple wavelengths could be imaged sequentially on the same camera, to obtain a sequence of individual images, each corresponding to a different wavelength. Alternatively, each of these wavelengths could be imaged in parallel on separate cameras (or separate regions of the same camera), with the wavelengths being separated using suitable optical components such as dichroic mirrors. In another embodiment, it is possible to measure multiple wavelengths (and diffraction orders) in a single camera image. When illumination beams corresponding to different wavelengths are at the same location in the pupil, the corresponding fringes on the camera image will have different orientations for the different wavelengths. This will tend to be the case for most off-axis illumination generator arrangements (an exception is a single grating, for which the wavelength dependence of the illumination grating and target grating tend to cancel each other). By appropriate processing of such an image, alignment positions can be determined for multiple wavelengths (and orders) in a single capture. These multiple positions can e.g. be used as an input for OCW-like algorithms.

Also described in WO 2020/057900 is the possibility of variable region of interest (ROI) selection and variable pixel weighting to enhance accuracy/robustness. Instead of determining the alignment position based on the whole target image or on a fixed region of interest (such as over a central region of each quadrant or the whole target; i.e., excluding edge regions), it is possible to optimize the ROI on a per-target basis. The optimization may determine an ROI, or plurality of ROIs, of any arbitrary shape. It is also possible to determine an optimized weighted combination of ROIs, with the weighting assigned according to one or more quality metrics or key performance indicators (KPIs).

Also known is color weighting and using intensity imbalance to correct the position at every point within the mark, including a self-reference method to determine optimal weights, by minimizing variation inside the local position image.

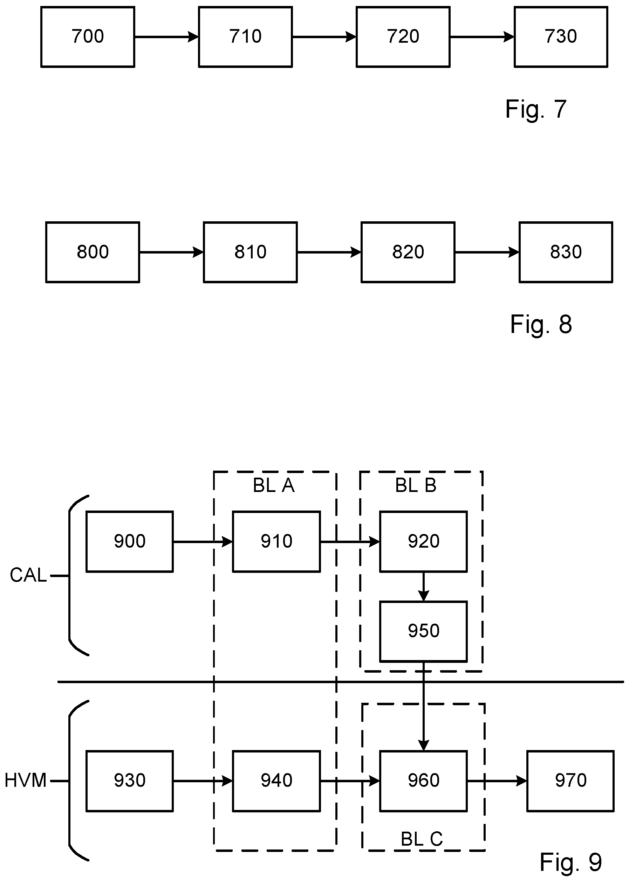

Putting these concepts together, a known baseline fitting algorithm may comprise the steps illustrated in the flowchart of Figure 7. At step 700, a camera image of the alignment mark is captured. The stage position is known accurately and the mark location known coarsely (e.g., within about 100nm) following a coarse wafer alignment (COWA) step. At step 710 an ROI is selected, which may comprise the same pixel region per mark (e.g., a central region of each mark grating). At step 720 a sine fit is performed inside the ROI, with the period given by the mark pitch to obtain a phase measurement. At step 730, this phase is compared to a reference phase, e.g., measured on a wafer stage fiducial mark.

For numerous reasons it is increasingly desirable to perform alignment on smaller alignment marks/targets or more generally to perform metrology on smaller metrology targets. These reasons include making the best use of available space on the wafer (e.g., to minimize the space taken used by alignment marks or targets and/or to accommodate more marks/targets) and accommodating alignment marks or targets in regions where larger marks would not fit.

According to present alignment methods, for example, wafer alignment accuracy on small marks is limited. Small marks (or more generally targets) in this context may mean marks/targets smaller than $12\mu m$ or smaller than $10\mu m$ in one or both dimensions in the substrate plane (e.g., at least the scanning direction or direction of periodicity), such as $8\mu m \times 8\mu m$ marks.

For such small marks, phase and intensity ripple is present in the images. With the baseline fitting algorithm described above in relation to Figure 7 (which is a relatively straightforward way to fit the phase of a fringe on a very small part of a mark), the ripple corresponds to a significant fraction of the local alignment position. This means that, even when averaged over e.g. a $5\times5\mu m$ ROI, the ripple does not sufficiently average out. In addition, in order to optimize accuracy, it is important to identify bad mark areas and eliminate or correct those areas. For example, if there are locally displaced or locally asymmetric grating lines which lead to local position error in the order of nanometers, then it is desirable that this is visible or can be determined, so that it can be corrected for. However, if there is a ripple due to finite size effects (also called "phase envelope"), resulting from the finite size of the target and having a magnitude larger than that of process-induced local defects, then it is not possible to correct for the latter.

Methods will be described which improve measurement accuracy by enabling correction of such local position errors (or local errors more generally) on small marks, the measurement of which is subject to finite size effects.

Figure 8 describes the basic flow for determining a parameter of interest (e.g., a position/alignment value or overlay value) according to concepts disclosed herein. At step 800, a raw metrology sensor signal is obtained. At step 810, the raw signal is pre-processed to minimize or at least mitigate impact of finite mark size (and sensor) effects to obtain a pre-processed metrology signal. It is this step which is the subject of this disclosure and will be described in detail below. At optional step 820, the pre-processed metrology signal may be (e.g., locally) corrected for mark processing effects (e.g., local mark variation). Targets generally, and small targets in particular, typically suffer deformations during their formation (e.g., due to processing and/or exposure conditions). In many cases, these deformations are not uniform within the target, but instead comprise multiple local or within-target effects leading to local or within-target variation; e.g., random edge effects, wedging over the mark, local grating asymmetry variations, local thickness variations and/or (local) surface roughness. These deformations may not repeat from mark-to-mark or wafer-to-wafer, and therefore may be measured and corrected prior to exposure to avoid misprinting the device. This optional step may provide a within-target correction which corrects for such alignment mark defects for example. This step may comprise measuring a local position measurement (e.g., a position distribution or local position map) from a target. A position distribution may describe variation of aligned position over a target or at least part of the target (or a captured image thereof); e.g., a local position per pixel or per pixel group (e.g., groups of neighboring pixels) and determining the correction as that which minimizes variance in the position distribution. At step 830, the position value (or other parameter of interest, e.g., overlay) is determined, e.g., after optimizing ROI and averaging within.

*High-level overview*

.Figure 9 is a high-level overview of a proposed concept. In general, methods disclosed herein may described by a number of combinations of a set of "building blocks" BL A, BL B, BL C. For each building block, a number of different embodiments will be described. The embodiments explicitly disclosed for each block is not exhaustive, as will be apparent to the skilled person.

In general, there are two different phases of signal acquisition:

- A calibration phase CAL, where signals are recorded in order to calibrate a model and/or library which is further used for correction (e.g., in a production phase). Such a calibration phase may be performed once, more than once or every time.
- A "high-volume manufacturing" HVM or production phase, where signals are recorded to extract the metrology quantity of interest. This is the basic functionality / main use of the metrology sensor. The "acquisition signal" or the "test signal" fitted in the HVM phase is not necessarily acquired in the HVM phase, but could be acquired at any other phase of the manufacturing process.

Considering first the calibration phase, at step 900, calibration data, comprising one or more raw metrology signals, are obtained from one or more marks. At step 910, an extraction of "local phase" and "local amplitude" is performed from the fringe pattern of the raw metrology signals in the calibration data. At step 920, a correction library may be compiled to store finite-size effect correction data comprising corrections for correcting the finite-size effect. Alternatively or in addition, step 920 may comprising determining and/or training a model (e.g., a machine learning model) to perform finite-size effect correction. In the production or HVM phase, a signal acquisition is performed (e.g., from a single mark) at step 930. At step 940, an extraction of "local phase" and "local amplitude" is performed from the fringe pattern of the signal acquired at step 930. At step 950 a retrieval step is performed to retrieve the appropriate finite-size correction data (e.g., in a library based embodiment) for the signal acquired at step 930. At step 960, a correction of the finite-size effects is performed using retrieved finite-size effect correction data (and/or the trained model as appropriate) to obtain corrected measurement data. Step 970 comprises analysis and further processing step to determine a position value or other parameter of interest.

Note that, in addition or as an alternative to actual measured calibration data and/or correction local parameter distributions derived therefrom, the calibration data/ correction local parameter distributions may be simulated. The simulation for determining the correction local parameter distributions may comprise one or more free parameters which may be optimized based on (e.g., HVM-measured) local parameter distributions.

Many specific features will be described, which (for convenience) are divided according to the three blocks BL A, BL B, BL C of Figure 9.

*Block A. Extraction of the local phase.*

*Feature A1. Local phase as a spatially weighted fit ("local APD").*

In a first embodiment of block A, a locally determined position distribution (e.g., a local phase map or local phase distribution or more generally a local parameter map or local parameter distribution), often referred to local aligned position deviation LAPD, is used directly, i.e., not combined with mark template subtraction, database fitting, envelopes, etc.. to calibrate a correction which minimizes the finite size effects.

At high level, such a local phase determination method may comprise the following. A signal $S(x,y)$ (a 2D signal, e.g., a camera image will be assumed, but the concepts apply to signals in any dimension), is mapped into a set of spatial-dependent quantities $\alpha_n(x,y)$, $n$ = 1,2,3,4 ... which are related to the metrology parameter of interest. The mapping can be achieved by defining a set of basis functions, e.g., $B_n(x,y)$, $n$ = 1,2,3,4 ...; and, for every pixel position (x,y), fitting coefficients $\alpha_n(x,y)$ which minimize a suitable spatially weighted cost function, e.g.,:

$$CF[\,\alpha_n\,] = \sum_{x'}\sum_{y'} K(x - x', y - y')\, f\,[S(x', y') - \sum_n \alpha_n(x,y) B_n(x', y')]$$

The function $f(\cdot)$ can be a standard least square cost function (L2 norm: $f(\cdot) = (\cdot)^2$), an L1 norm, or any other suitable cost function.

The weight $K(x - x', y - y')$ is in general a spatially localized function around the point (x,y). The "width" of the function determines how "local" the estimators $\alpha_n(x,y)$ are. For instance, a "narrow" weight means that only points very close to (x,y) are relevant in the fit, and therefore the estimator will be very local. At the same time, since fewer points are used, the estimator will be noisier. There are infinite choices for the weights. Examples of choices (non-exhaustive) include:

- Exponential: $K(x - x', y - y') = \exp\left(-\gamma_x (x - x')^2 + \gamma_y (y - y')^2\right)$
- Factorized Bessel function: $K(x - x', y - y') = B(x - x')B(y - y')$
- Radial function: $K(x - x', y - y') = R\left(\sqrt{(x - x')^2 + (y - y')^2}\right)$
- Any apodization window, eg. Hamming window
- Any finite-input-response (FIR) filter
- A function matching the point spread function of the optical sensor, either analytically approximated, simulated, or experimentally measured

The person skilled in the art will recognize that there are infinitely more functions with the desired "localization" characteristics which may be used. The weight function can also be optimized as part of any process described in this IDF.

For the specific case of a signal containing one or more (also partial or overlapping) fringe patterns with "fringe" wavevectors $k^{(A)}, k^{(B)}$, etc., a suitable choice for the basis function may be (purely as an example):

- $$B_1(x,y) = 1 \quad \text{(a DC component)}$$

- $$B_2(x,y) = \cos\left(k_x^{(A)}x + k_y^{(A)}y\right)$$

"in-phase" component A

- $$B_3(x,y) = \sin\left(k_x^{(A)}x + k_y^{(A)}y\right)$$

"quadrature" component A

- $$B_4(x,y) = \cos\left(k_x^{(B)}x + k_y^{(B)}y\right)$$

"in-phase" component B

- $$B_5(x,y) = \sin\left(k_x^{(B)}x + k_y^{(B)}y\right)$$

"quadrature" component B

- etc.

Of course, there exist many different mathematical formulations of the same basis functions, for instance in terms of phases and amplitudes of a complex field.

With this basis choice, two further quantities of interest may be defined for every fringe pattern:

- The local phases: $\phi_A(x,y) = atan2(\alpha_3(x,y),\ \alpha_2(x,y))$, $\phi_B(x,y) = atan2(\alpha_5(x,y),\ \alpha_4(x,y))$
- The local amplitudes: $A_A(x,y) = (\alpha_2(x,y)^2 + \alpha_3(x,y)^2)^{1/2}$, $A_B(x,y) = (\alpha_4(x,y)^2 + \alpha_5(x,y)^2)^{1/2}$

The local phase is particular relevant, because it is proportional to the aligned position (LAPD) as measured from a grating for an alignment sensor (e.g., such as described above in relation to Figures 3 to 6). As such, in the context of alignment, LAPD can be determined from the local phase map or local phase distribution. Local phase is also proportional to the overlay measured, for instance, using a cDBO mark. Briefly, cDBO metrology may comprise measuring a cDBO target which comprises a type A target or a pair of type A targets (e.g., per direction) having a grating with first pitch $p_1$ on top of grating with second pitch $p_2$ and a type B target or pair of type B targets for which these gratings are swapped such that a second pitch $p_2$ grating is on top of a first pitch $p_1$ grating. In this manner, and in contrast to a μDBO target arrangement, the target bias changes continuously along each target. The overlay signal is encoded in the Moiré patterns from (e.g., dark field) images.

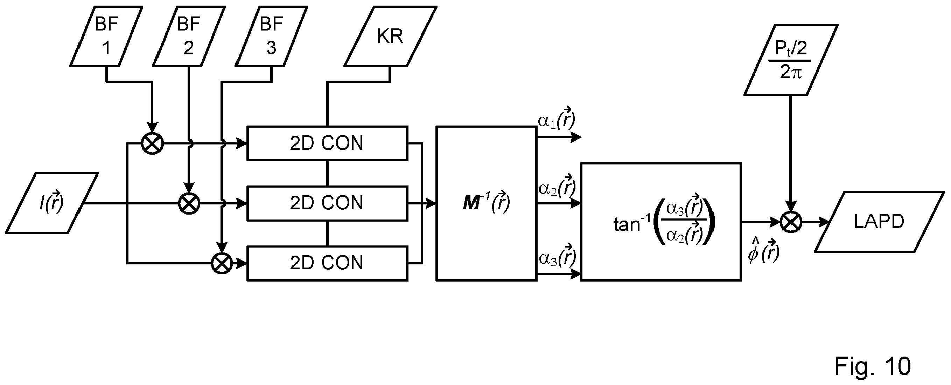

In the very specific use case of: an image with a single fringe pattern to be fitted (3 basis function as described above), and the cost function being the standard L2 norm, the algorithm becomes a version of weighted least squares, and can be solved with the efficient strategy outlined in Figure 10 for a fringe pattern $I(\vec{r})$ and known wavevector $k$ (determined from mark pitch and wavelength used to measure). Basis functions BF1 $B_1(\vec{r})$, BF2 $B_2(\vec{r})$, BF3 $B_3(\vec{r})$ are combined with the fringe pattern $I(\vec{r})$ and are 2D convolved (2D CON) with a spatial filter kernel KR $K(\vec{r})$ of suitable cut-off frequency e.g., $\frac{1}{2}\sqrt{k_x^2 + k_y^2}$. A position dependent 3x3 matrix $\mathbf{M}^{-1}(\vec{r})$ is constructed with elements $\mathbf{M}_{i,j}(\vec{r}) = (W * B_iB_j)(\vec{r})$ which is inverted at each point.

**Feature A2. Approximate spatially weighted fit**

This feature is similar in principle to feature A1. The idea is to multiply the signal by the basis functions

$$P_n(x,y) = S(x,y)B_n(x,y)$$

and then convolving the resulting quantities with the kernel $K(x - x', y - y')$

$$\tilde{\alpha}(x,y) = \sum_{x'}\sum_{y'} K(x-x',y-y')P(x',y')$$

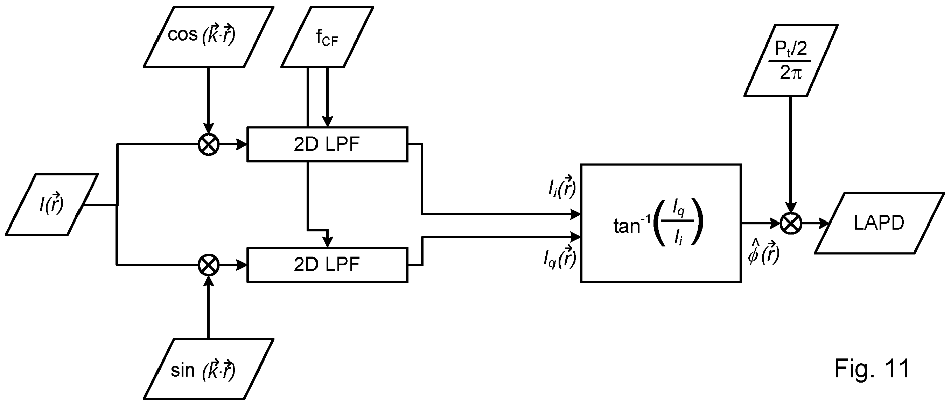

In a particular case (when the basis function are orthogonal under the metric induced by the kernel), the quantities $\tilde{\alpha}_n$ coincides with the quantities $\alpha_n$ of option A1. In the other cases, they are an approximation, which can be reasonably accurate in practice. This embodiment is summarized in Figure 11 based on Quadrature detection where the measured signal is multiplied with expected quadratures (sine and cosine) and low pass filtered (2D) LPF to extract local amplitude and phase using the same basic principle as a lock-in amplifier.

*Feature A3. Envelope fitting*

The idea behind envelope fitting is to use a set of signal acquisitions instead of a single signal acquisition to extract the parameter of interest. The index "J = 1,2,3,4,..." is used to designate the different signal acquisitions. The signal acquisitions may be obtained by measuring the same mark while modifying one or more physical parameters. Non-exhaustive examples include:

- Varying the X and/or Y position of the mark via a mechanical stage;
- Varying the X and/or Y position of any optical element (including for example the metrology sensor illumination grating);
- Inducing a phase shift in the optical signal by means of a phase modulator of any kind.

Given a signal acquisition $S_J(x,y)$ (e.g., a 2D image), the following model for the signal is assumed:

$$\tilde{S}_J(x,y) = \sum_n C_{nJ}\, \alpha_n(x - \Delta x_J, y - \Delta y_J)\, B_n(x - \Delta x_J, y - \Delta y_J)$$

where $B_1(x,y)$, $B_2(x,y)$, *etc.* are basis functions, as in the previous options, and the quantities $\alpha_n(x,y)$ and $C_{nJ}, \Delta x_J$, and $\Delta y_J$ are the parameters of the model. Note that the dependence $C_{nJ}, \Delta x_J, \Delta y_J$ is now on the acquisition and not on the pixel position (they are global parameters of the image), whereas $\alpha_n(x,y)$ depends on the pixel position, but not on the acquisition (they are local parameters of the signal).

In the case of a fringe pattern, using the same basis as in feature A1, yields:

$$
\begin{aligned}
\tilde{S}_J(x,y) = &\; C_{1J}\, \alpha_1\big(x - \Delta x_J, y - \Delta y_J\big) \\
&+ C_{2J}\, \alpha_2\big(x - \Delta x_J, y - \Delta y_J\big) \cos\left(k_x^{(A)}(x - \Delta x_J) + k_y^{(A)}(y - \Delta y_J)\right) \\
&+ C_{3J}\, \alpha_3\big(x - \Delta x_J, y - \Delta y_J\big) \sin\left(k_x^{(A)}(x - \Delta x_J) + k_y^{(A)}(y - \Delta y_J)\right) \\
&+ C_{4J}\, \alpha_4\big(x - \Delta x_J, y - \Delta y_J\big) \cos\left(k_x^{(B)}(x - \Delta x_J) + k_y^{(B)}(y - \Delta y_J)\right) \\
&+ C_{5J}\, \alpha_5\big(x - \Delta x_J, y - \Delta y_J\big) \sin\left(k_x^{(B)}(x - \Delta x_J) + k_y^{(B)}(y - \Delta y_J)\right) + \cdots
\end{aligned}
$$

Note that this formulation is mathematically equivalent to:

$$\tilde{S}_J(x,y) = C_{1J}\,\alpha_1(x,y) +$$

$$S_J^{(A)} A_A\big(x - \Delta x_J, y - \Delta y_J\big) \cos\Big(k_x^{(A)}\big(x - \Delta x_J\big) + k_y^{(A)}\big(y - \Delta y_J\big) + \phi_A\big(x - \Delta x_J, y - \Delta y_J\big) + \Delta\phi_J^{(A)}\Big)$$

$$+\; S_J^{(B)} A_B\big(x - \Delta x_J, y$$

$$- \Delta y_J\big)\cos\Big(k_x^{(B)}\big(x - \Delta x_J\big) + k_y^{(B)}\big(y - \Delta y_J\big) + \phi_B\big(x - \Delta x_J, y - \Delta y_J\big) + \Delta\phi_J^{(B)}\Big)$$

$$+\cdots$$

This formulation is illustrative of the physical meaning of the model. The physical interpretation of the quantities is as follows:

- "phase envelopes" of the fringe pattern: $\phi_A(x,y)$, $\phi_B(x,y)$
- "amplitude envelopes" of the fringe pattern: $A_A(x,y)$, $A_B(x,y)$
- Global scaling factors: $S_J^{(A)}$, $S_J^{(B)}$
- global dephasing: $\Delta\phi_J^{(A)}$, $\Delta\phi_J^{(B)}$
- global displacement: $\Delta x_J$, $\Delta y_J$

The relation between the parameters in the various equivalent formulations can be determined using basic algebra and trigonometry. For many embodiments, the "phase envelope" is the important quantity, because it is directly related to the aligned position of a mark in the case of an alignment sensor (e.g., as illustrated in Figures 3 to 6).

In order to fit the parameters of the model, the following cost function may be minimized:

$$CF = \sum_J \sum_x \sum_y f[\tilde{S}_J(x,y) - S_J(x,y)]$$

The function $f$ can be a L2 norm (least square fit), an L1 norm, or any other choice. The cost function does not have to be minimized over the whole signal, but can only be minimized in specific regions of interest (ROI) of the signal.

There are various ways in which the model parameters can be treated:

- $\alpha_n(x,y)$ are the fitting parameters (unknowns), whereas $C_{nJ}$ $C_{nJ}, \Delta x_J$ and $\Delta y_J$ are assumed to be known. In this case we have NxM unknowns, where N = number of pixels, M = size of the basis, and therefore at least M independent signal acquisitions are required. The parameters $C_{nJ}, \Delta x_J$ and $\Delta y_J$ are obtained (for instance) from some additional measurement, from an external sensor, or from calculations / estimates.
- $C_{nJ}, \Delta x_J$ and $\Delta y_J$ (or a subset of them) are the fitting parameters and $\alpha_n(x,y)$ are assumed to be known. This is relevant in the cases where the quantity that is measured by the metrology system is a global quantity, for instance the global displacements $\Delta x_J$ and $\Delta y_J$. The parameters $\alpha_n(x,y)$ (known parameter) may be derived, for example, from any of the calibration processes described below. This case is further discussed in the context of feature C3.
- All parameters $\alpha_n(x,y)$, $C_{nJ}$ $\Delta x_J$ and $\Delta y_J$ are unknown. In this case the fit becomes a nonlinear and/or iterative fit. Mathematical optimization methods can be used to minimize the cost function. Additional constraints among parameters may be imposed, as derived from physical considerations, observations, or a purely empirical basis. In this case the number of unknowns is NxM + MxP + 2, where N = number of pixels, M = size of the basis, and P = number of acquisitions. The number of known parameters is N x P, so, given that typically N»M, the system is solvable provided that there are more images than basis functions (P>M).
- Of course, intermediate cases where some of the parameters are known and some are unknown are obvious generalizations of the previous cases and are also part of this disclosure.

*Feature A4. Sensor-corrected envelope fitting*

This option is a generalization of feature A3, with an increased number of fitting parameters. In this feature, the model for the signal may be assumed to be:

$$\tilde{S}_J(x,y) = \sum_n C_{nJ} \, \alpha_n(x - \Delta x_J, y - \Delta y_J) \; B_n\big(x - \Delta x_J, y - \Delta y_J\big) + \sum_n D_{nJ} \, \beta_n(x,y) \; B'_n(x,y)$$

$$+ \sum_n F_{nJ} \, \gamma_n\big(x - \Delta x_J, y - \Delta y_J\big) \, \delta_n(x,y) \; B_n\big(x - \Delta x_J, y - \Delta y_J\big) B'_n(x,y)$$

The model parameters are $\alpha_n(x,y)$, $\beta_n(x,y)$, $\gamma_n(x,y)$, $\delta_n(x,y)$, $C_{nJ}$, $D_{nJ}$, $F_{nJ}$, $\Delta x_J$, $\Delta y_J$. All the considerations regarding the parameters discussed above for feature A3 are valid for this feature. The additional parameters account for the fact that some of the effects described by the model are assumed to shift with the position of the mark, whereas other effects "do not move with mark" but remain fixed at the same signal coordinates. The additional parameters account for these effects separately, and also additionally account for the respective cross-terms. Not all parameters need to be included. For example, $C_{nJ} = D_{nJ} = 0$ may be assumed to reduce the number of free parameters etc.. For this specific choice, for example, only the cross-terms are retained in the model.

This model may be used to reproduce a situation where both mark-dependent and non-mark-specific effects are corrected. Using the example of an image signal, it is assumed that there are two kinds of effects:

- Local effects which "move with the mark" in the field of view: they are shifted by displacement $(\Delta x_J, \Delta y_J)$ that changes from acquisition to acquisition. Therefore, all the related quantities are a function of $(x - \Delta x_J, y - \Delta y_J)$ in the model above.
- Local effects that "do not move with mark": these are local deviations of the signal due to non mark-specific effects, for instance defects or distortion of the camera grid, defects or distortions in any optical surface, ghosts, etc.. In the model, these effects are always found at the same pixel coordinate $(x,y)$ within different acquisitions.

The model also account for the coupling between these two families of effects (third term in the equation).

In a possible embodiment, the non-mark-specific effects may have been previously calibrated in a calibration stage (described below). As a result of such calibration, the parameters $\beta_n(x,y)$, $\delta_n(x,y)$ are known as calibrated parameters. All the other parameters (or a subset of the remaining parameters) are fitting parameters for the optimization procedure.

*Feature A5. Pattern recognition*

Pattern recognition can also be used as a method to obtain global quantities from a signal; for example, the position of the mark within the field of view.

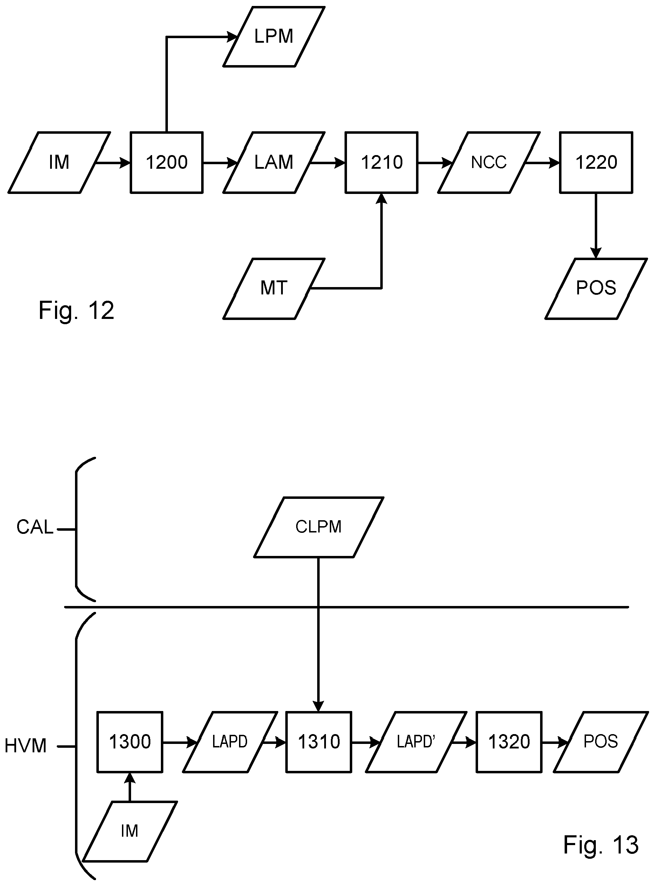

Figure 12 illustrates a possible example of this feature. In a possible embodiment, any of the features A1-A4 (step 1200) may be used to obtain one or more local parameter maps or local parameter distributions, such as a local phase map or local phase distribution LPM (and therefore LAPD as described above) and a local amplitude map or local amplitude distribution LAM, from a measured image IM. Image registration techniques 1210 can then be used to register the position of a mark template MT on the local amplitude map LAM. Possible examples of registration techniques 1210 are based on maximizing:

- The normalized cross-correlation;
- The mutual information;
- any other suitable property.

Moreover, in addition to the local amplitude map, additional information can be used in the image registration process 1210. Such additional information may include one or more of (*inter alia*): the local phase map LPM, the gradient of the local amplitude map, the gradient of the local phase map or any higher-order derivatives.

In the case of an image encompassing multiple fringe patterns, the local amplitude maps of all the fringe patterns can be used. In this case, the image registration may maximize, for example:

- The product of the cross-correlation, or the product of the mutual information etc.
- The sum of the cross-correlation, or the sum of the mutual information, etc.
- Any other combination of the optimization cost function of each single map

The result of image registration 1210 step may be (for example) a normalized cross-correlation NCC, from which the peak may be found 1220 to yield the position POS or (x,y) mark center within the field of view.

*Block B. Calibrating and retrieving the correction data*

*Feature B1: Single reference correction*

In a calibration phase, the "phase ripple" (i.e., the local phase image caused by finite size effects) may be measured (or simulated or otherwise estimated) on a single reference mark or averaged over multiple (e.g., similar) marks to determine a correction local parameter map or correction local parameter distribution (e.g., correction local parameter map or reference mark template) for correction of (e.g., for subtraction from) HVM measurements. This may be achieved by using any of the features defined in block A, or any combination or sequence thereof. Typically the reference mark is of the same mark type as the mark to be fitted. The reference mark may be assumed to be 'ideal' and/or a number of reference marks may be averaged over so that reference mark imperfections are averaged out.

Figure 13 is a flowchart which illustrates this feature. A measurement or acquisition image IM is obtained and a local fit 1300 performed thereon to yield a local parameter map (e.g., local phase map or local aligned position map) LAPD (e.g., using any of the features of block A). When fitting a mark in a HVM or production phase (where it may be assumed that the marks suffer from (local) processing effects / imperfections), a correction local parameter map (distribution) CLPM may be used to correct 1310 the aligned position map LAPD, using (for example) the methods described in the Block C section (below). The local parameter map or local parameter distribution CLPM may comprise a correction phase map, correction LAPD distribution or expected aligned position map. In an embodiment, the correction local parameter map CLPM may comprise only the deviation from the "correct" phase map i.e., only the "ripple"/undesired deviations caused by finite size and other physical effects. The correction step 1310 may eliminate or mitigate the finite size effects from the local parameter map or aligned position map LAPD using the correction local parameter map CLPM. In the resulting corrected local parameter map or corrected aligned position map LAPD', only residual mark imperfections which result from differences between the mark and the reference mark should remain. This corrected aligned position map LAPD' can be used to determine 1320 a position value POS.

The correction local parameter map CLPM or expected aligned position map used for the correction may be determined in a number of different methods, for example:

1) Measured on wafer stage fiducial or calibration wafer (in alignment sensor setup sequence).
2) Via simulation.
3) Estimated based on a similar layer.
4) Measured on a wafer comprising the actual stack to be measured/aligned in HVM (e.g., in a research or calibration phase).
5) Measured on a wafer comprising the actual stack during HVM in shadow mode (in which case the calibration data may comprise actual product data).

The latter two approaches will give best performance as they use the correct stack and sensor.

*Feature B2: library fitting with index parameter*

This feature is a variation of feature B1, where a number of correction local parameter maps CLPM (e.g., reference mark template) are determined and stored in a calibration correction database or library, each indexed by an index variable. A typical index variable might be the position of the mark with respect to the sensor. This position can be exactly defined as, for example:

o position with respect to illumination grating inside sensor;
o position with respect to camera (this may be different than the position with respect to illumination grating, in case drift occurs inside the sensor);
o both of the above (this may require a higher-dimensional library, in which case the expected mark shape depends on both the position with respect to illumination grating and on position with respect to camera).

*Library creation*

In a first stage of the calibration process, the correction local parameter maps (e.g., local phase maps) of a set of different signal acquisitions (calibration data) are determined, e.g., by using any of the methods described in block A. As in the previous feature, the set of acquisitions does not have to be measured, but can also be simulated or otherwise estimated.

In addition, an index variable is determined for every image acquisition. For instance, the index variable can be an estimate of the position of the mark with respect to the sensor. The index variable can be obtained from difference sources; for example:

- It can be computed using any of the methods in block A;
- It can be computed using any other analysis procedure from the acquisition signal;
- It can come from an external source, for instance: the detected position displacement of the wafer stage in the scanner, or the output of any other sensor;
- It can come from a feedforward or feedback process loop.

The library of correction local parameter maps together with the corresponding index variables may be stored such that, given a certain index value, the corresponding correction local parameter map can be retrieved. Any method can be used for building such library. For example:

- The correction local parameter map may be retrieved corresponding to the stored index variable that is the closest to the required index variable;
- An interpolation strategy may be used to interpolate the correction local parameter map as function of the required index variable;
- A neural network or any other form of advance data processing may be used to map the required index variable to the output correction local parameter map.

The correction local parameter maps do not necessarily need to comprise only local phase maps or local position maps (or "ripple maps" comprising description of the undesired deviations caused by finite size and other physical effects). Additional information, for example the local amplitude map or the original image can also be stored in the library and returned for the correction process.

The range of the index variable might be determined according to the properties of the system (e.g., the range covered during fine alignment; i.e., as defined by the accuracy of an initial coarse alignment). Before this fine wafer alignment step, it may be known from a preceding "coarse wafer alignment" step that the mark is within a certain range in x,y. The calibration may therefore cover this range.

Other observations:

- If needed, the library could also contain correction images as function of focus position (z);
- The library could also contain correction images as function of global wafer coordinate (if there is e.g., a global variation over the wafer that causes the expected mark shape to vary over the wafer).
- The library could also contain correction images as function of field coordinate (if e.g., the expected mark shape depends on location in the field, for example because surrounding structures may impact expected mark shape and may depend on location in the field).
- The library could also contain correction images as function of wafer Rz.
- The index parameter may comprise a lot or process-tool related index parameter.
- If needed, the library could also contain correction images as function of many other parameters.
- In the correction library, it may be that only the deviation (or error distribution) from the "correct" (nominal) phase map is stored i.e., the library only describes the "ripple"/undesired deviations caused by finite size and other physical effects.

*Retrieval of the correction parameters*

When a mark is fitted (e.g. in a HVM high-volume manufacturing phase), a single image of the mark may be captured and an aligned position map determined therefrom using a local fit (e.g., as described in Block A). To perform the correction, it is required to know which correction local parameter map (or more generally correction image) from the library to use.

To do this, the index parameter may be extracted from the measured image, using one of the methods by which the index parameter had been obtained for the library images (e.g., determined as a function of the mark position of the measured mark with respect to the sensor). Based on this, one or more correction local parameter maps (e.g., local phase map, local amplitude map, etc.) can be retrieved from the library using the index variable, as described above.

As an example, one way to solve this is by performing a pre-fine wafer alignment fit (preFIWA fit), in which the position with respect to the sensor is determined to within a certain range, which may be larger than the desired final accuracy of the metrology apparatus. The preFIWA fit is described in feature A5.

Note that in a more general case, other parameter information e.g., focus, global wafer or field location, etc. may be used to determine the correct correction image from the database (e.g., when indexed according to these parameters as described above).

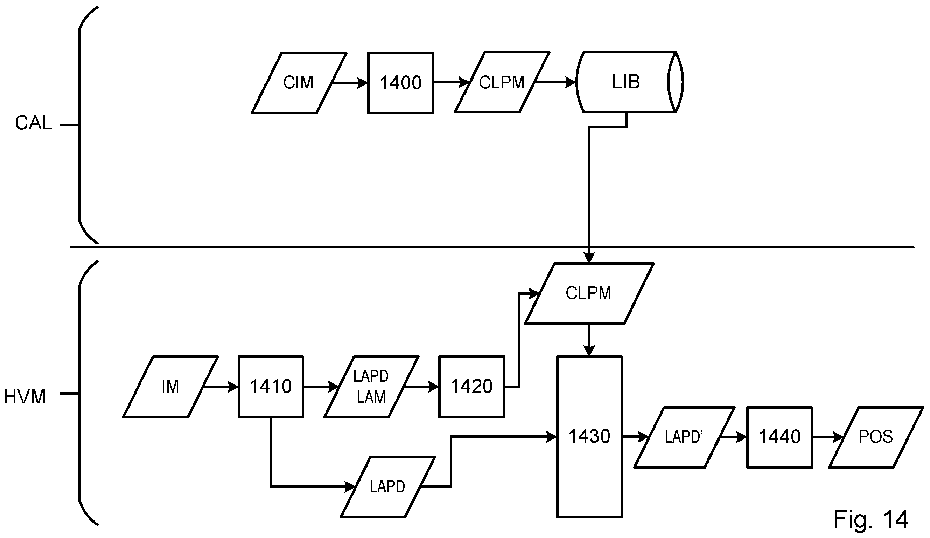

Figure 14 is a flowchart summarizing this section. In a calibration phase CAL, calibration data comprising calibration images CIM of reference marks at (for example) various positions (or with another parameter varied) undergo a local fit step 1400 to obtain correction local parameter maps CLPM or reference aligned position maps. These are stored and (optionally) indexed in a correction library LIB. In a production phase HVM, an alignment acquisition or alignment image IM undergoes a local fit 1410 to obtain local aligned position map LAPD and (optionally) a local amplitude map LAM. Both of these may undergo a preFIWA fit 1420. A correction local parameter map CLPM or expected aligned position map is interpolated from the library LIB based on the preFIWA fit, and this is used with the local aligned position map LAPD in a correction determination step 1430 to determine a corrected local aligned position map LAPD' comprising only residual mark imperfections which result from differences between the mark and the reference mark. This corrected aligned position map LAPD' can be used to determine 1440 a position value POS.

*Feature B3. Library fitting without "index variable"*

This feature is similar to feature B2. In feature B2, a set of acquisition data was processed and the results of the processing are stored as a function of an "index variable". Later on, when an acquisition signal or test signal is recorded (e.g., in a production phase), the index variable for the acquisition signal is calculated and used to retrieve the correction data. In this feature, the same result is accomplished without the use of the index variable. The acquisition signal is compared with the stored data in the library and the "best" candidate for the correction is retrieved, by implementing a form of optimization.

Possible options are:

- The phase maps $\phi(x, y)$ or phase distributions (correction local parameter maps) of a set of calibration acquisitions are computed using any of the methods in block A. The phase map $\phi_{acq}(x, y)$ of the acquisition image (e.g., during production) is also computed. The phase map used for correction $\phi_{corr}(x,y)$ may comprise the one that minimizes a certain cost function, for example:

$$CF[\phi_{acq}] = \sum_{x,y} f[\phi_{acq}(x,y), \phi_{corr}(x,y)]$$

  The function $f$ can be any kind of metric, for instance a L2 norm, a L1 norm, (normalized) cross-correlation, mutual information, etc. Other slightly different cost functions, also not directly expressible in the form above, can be used to reach the same goal.
- The phase map of a set of calibration acquisitions are computed and stored as a function of one or more index variables, V, as described in feature B2. In this way, a library $\phi_{library}(V; x,y)$ is generated. After an acquisition signal is acquired (e.g., during production), a phase map to be used for correction is retrieved. This correction phase map corresponds to an "optimal" value of the index variable $V_{opt}$ which makes the correction map as similar as possible to the acquisition signal map. "Similarity" may be evaluated in terms of an appropriate cost function, e.g.:

$$CF[V_{opt}] = \sum_{x,y} f[\phi_{library}(V_{opt}; x,y), \phi_{corr}(x,y)]$$

  The function $f$ can be any kind of metric, for instance a L2 norm, a L1 norm, (normalized) cross-correlation, mutual information, etc.. Other slightly different cost functions, also not directly expressible in the form above, can be used to reach the same goal.
  The difference with feature B2 is that now the "index variable" of the acquisition signal is not computed explicitly, but it is deduced by an optimality measure.
- All the concepts described above may also be applied to the amplitude map in place of or in addition to the phase map (or to a combination of the phase and the amplitude maps). The concepts may also be applied to different fringe patterns within the same signal.
- All the concepts described above may also be applied to the gradient of the phase or amplitude map, or derivatives of any order, or any combination thereof and with the original maps.
- All the concepts described above may also be applied to the original signal itself, alone or in combination with phase maps, amplitude maps, or derivatives thereof.

*Feature B4: machine learning*

This feature describes methods to obtain and retrieve the correction parameter (e.g., aligned position) using some form of "artificial intelligence", "machine learning", or similar techniques. In practice, this feature accompanies feature C4: there is a relation between the calibration of the finite-size effects and the application of the calibrated data for the correction. In the language of "machine learning", the calibration phase corresponds to the "learning" phase and is discussed here.

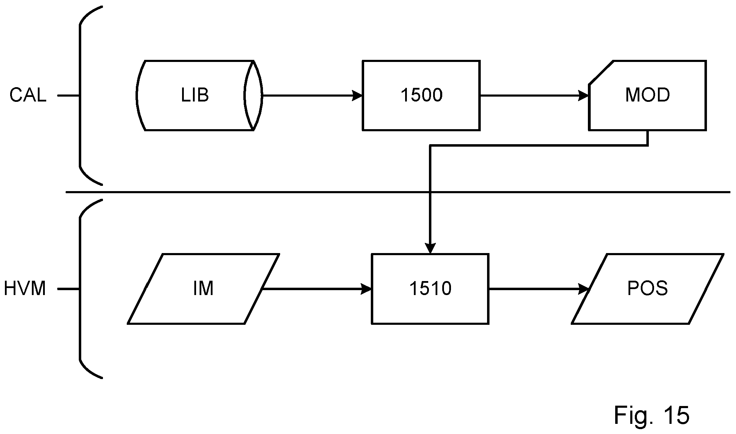

Figure 15 is a flowchart describing such a method. Calibration data such as a set of signals (calibration images) or library of images LIB is acquired. Such signals could also be simulated or computed with other techniques. These signals may be related to the same mark, and be labeled by some quantity. For example, signals might be labeled by the metrology quantity of interest (e.g., the aligned position); i.e., the corresponding metrology quantity is known for each signal (ground truth). Alternatively, the signals may be labeled with any of the index variables discussed beforehand.

A machine learning technique is used to train 1500 a model MOD (for instance, a neural network) which maps an input signal to the metrology quantity of interest, or to the index variable of interest.

Instead of the bare signals, all input signals may be processed using any of the features of Block A and mapped to local "phase maps" and "amplitude maps" (or correction local parameter maps) before being used to train the model. In this case, the resulting model will associate a correction local parameter map (phase, amplitude, or combination thereof) to a value of the metrology quantity or an index variable.

The trained model MOD will be stored and used in feature C4 to correct 1510 the acquired images IM to obtain a position value POS.

*Block C: correction strategy*

This block deals with the process of removing the local "mark envelope" from the acquired signal. It assumed that we have two different (sets of) local phase maps:

- An acquired local parameter map or local parameter distribution of an acquired signal or test signal;
- The correction local parameter map or correction local parameter distribution, which has been retrieved from the calibration data according to one of the methods of Block B.

The local parameter map and correction local parameter map may each comprise one or more of a local phase map, local amplitude map, a combination of a local phase map and local amplitude map, derivatives of a local phase map and/or local amplitude map or a combination of such derivatives. It can also be a set of local phase maps or local amplitude maps from different fringe patterns in the signal. It can also be a different set of maps, which are related to the phase and amplitude map by some algebraic relation (for instance, "in-phase" and "quadrature" signal maps, etc.). In block A some examples of such equivalent representations are presented.

The goal of this block is to use the "correction data" to correct the impact of finite mark size on the acquired test data.

**Feature C1: phase map subtraction**

The easiest embodiment is to subtract the correction local parameter map from the acquired local parameter map. Using a phase example, since phase maps are periodic, the result may be wrapped within the period.

$$\phi_{new}(x,y) = \phi_{acq}(x,y) - \phi_{corr}(x,y)$$

where $\phi_{new}(x,y)$ is the corrected local phase map, $\phi_{acq}(x,y)$ the acquired local phase map prior to correction and $\phi_{corr}(x,y)$ the correction local phase map.

**Feature C2: reformulation of the basis functions**

According to this feature, the acquired local phase and amplitude map of the acquired image are computed by using any of the methods in Block A. However, when applying the methods in Block A, the correction phase map and the correction amplitude map are used to modify the basis functions.

A "typical" (exemplary) definition of the basis functions was introduced in Block A:

- $$B_1(x,y) = 1$$

(a DC component)

- $$B_2(x,y) = \cos\left(k_x^{(A)}x + k_y^{(A)}y\right)$$

"in-phase" component fringe A

- $$B_3(x,y) = \sin\left(k_x^{(A)}x + k_y^{(A)}y\right)$$

"quadrature" component fringe A

- $$B_4(x,y) = \cos\left(k_x^{(B)}x + k_y^{(B)}y\right)$$

"in-phase" component fringe B

- $$B_5(x,y) = \sin\left(k_x^{(B)}x + k_y^{(B)}y\right)$$

"quadrature" component fringe B

- etc.

Suppose that a correction phase map $\phi_{corr}^{(A)}(x,y)$, and a correction amplitude map $A_{corr}^{(A)}(x,y)$ have been retrieved for some or all the fringe patterns in the signal. The modified basis functions may be constructed thusly:

- $$B_1(x,y) = 1$$

(a DC component)

- $$B_2(x,y) = A_{corr}^{(A)}(x,y)\cos\left(k_x^{(A)}x + k_y^{(A)}y + \phi_{corr}^{(A)}(x,y)\right)$$

"in-phase" component fringe A

- $$B_3(x,y) = A_{corr}^{(A)}(x,y)\sin\left(k_x^{(A)}x + k_y^{(A)}y + \phi_{corr}^{(A)}(x,y)\right)$$

"quadrature" component fringe A

- $$B_4(x,y) = A_{corr}^{(B)}(x,y)\cos\left(k_x^{(B)}x + k_y^{(B)}y + \phi_{corr}^{(B)}(x,y)\right)$$

"in-phase" component fringe B

- $$B_5(x,y) = A_{corr}^{(B)}(x,y)\sin\left(k_x^{(B)}x + k_y^{(B)}y + \phi_{corr}^{(B)}(x,y)\right)$$

"quadrature" component fringe B

- etc.

These modified basis functions may be used together with any of the methods in Sec. A (A1, A2, A3, etc..) in order to extract the phase and amplitude maps of the acquisition signal. The extracted phase and amplitude maps will be corrected for finite-size effects, because they have been calculated with a basis which includes such effects.

Of course, this feature may use only the phase map, only the amplitude map, or any combination thereof.

*Feature C3: Envelope fitting within ROI*

This feature is related to feature A3. The idea is to fit the acquisition signal using a model which includes the correction phase map $\phi_{corr}^{(A)}$, the correction amplitude map $A_{corr}^{(A)}$ and a correction DC map $D_{corr}$.

The model used may be as follows:

$$\tilde{S}\ (x,y) = C_1\, D_{corr}(x,y) +$$
$$S^{(A)} A_{corr}^{(A)}(x - \Delta x\ ,y$$
$$- \Delta y\ )\cos\left(k_x^{(A)}(x - \Delta x\ ) + k_y^{(A)}(y - \Delta y\ ) + \phi_{corr}^{(A)}(x - \Delta x\ ,y - \Delta y\ )\right.$$
$$\left. + \Delta\phi^{(A)}\right)$$
$$+ S^{(B)} A_{corr}^{(B)}(x - \Delta x\ ,y$$
$$- \Delta y\ )\cos\left(k_x^{(B)}(x - \Delta x\ ) + k_y^{(B)}(y - \Delta y\ ) + \phi_{corr}^{(B)}(x - \Delta x\ ,y - \Delta y\ )\right.$$
$$\left. + \Delta\phi^{(B)}\right) + \cdots$$

Note that this the same model as feature A3, with the following equalities

$$\phi_A = \phi_{corr}^{(A)}, \qquad A_A = A_{corr}^{(A)}, \qquad \alpha_1 = D_{corr,}$$

*etc.*

These quantities are not fitting parameters: they are known quantities because they have been retrieved from the correction library. As in the case of feature A3, there are other mathematically equivalent formulations of the model above, for instance in terms on in-phase and quadrature components.

On the other hand, the quantities $C_1, S^{(A)}, \Delta\phi^{(A)}$, etc., are fitting parameters. They are derived by minimizing a cost function, as in feature A3:

$$CF = \sum_J \sum_x \sum_y f[\tilde{S}_J(x,y) - S_J(x,y)]$$

The function *f* can be a L2 norm (least square fit), a L1 norm, or any other choice. The cost function does not have to be minimized over the whole signal, but instead may be minimized only in specific regions of interest (ROI) of the signals.

The most important parameters are the global phase shift $\Delta\phi^{(A)}, \Delta\phi^{(B)}$, because (in the case of an alignment sensor) they are directly proportional to the detected position of the mark associated with a given fringe pattern. The global image shifts $\Delta x$ and $\Delta x$ are also relevant parameters.

In general, it is possible that only a subset of parameters are used as fitting parameters, with others being fixed. The value of parameters may also come from simulations or estimates. Some specific constraints can be enforced on parameters. For instance, a relation (e.g., linear dependence, linear dependence modulo a given period, etc.) can be enforced during the fitting between the global image shifts $\Delta x$ and $\Delta x$ and the global phase shifts $\Delta\phi^{(A)}$, $\Delta\phi^{(B)}$.

*Feature C4: Machine learning*

This feature complements feature B4. According to feature B4, a model (e.g., neural network) has been trained that maps a signal to a value of the metrology quantity (e.g., aligned position), or to an index variable. In order to perform the correction, the acquisition signal is acquired and the model is applied to the signal itself, returning directly the metrology quantity of interest, or else an index variable. In the latter case, the index variable can be used in combination with a correction library such as those described in feature B2 to retrieve a further local correction map. This additional local correction map can be used for further correction using any of the features of Block C (above).

As noted above, the neural network may not necessarily use the raw signal (or only the raw signal) as input, but may use (alternatively or in addition) also any of the local maps ("phase", "amplitude") which are obtained with any of the features of Block. A.

*General remarks on the number of calibration steps*

In this document, a correction strategy is described based on a two-phase process: a "calibration" phase and a high-volume / production phase. There can be additional phases. In particular, the calibration phase can be repeated multiple times, to correct for increasingly more specific effects. Each calibration phase can be used to correct for the subsequent calibration phases in the sequence, or it can be used to directly correct in the "high-volume" phase, independently of the other calibration phases. Different calibration phases can be run with different frequencies (for instance, every lot, every day, only once in the R&D phase, etc.).

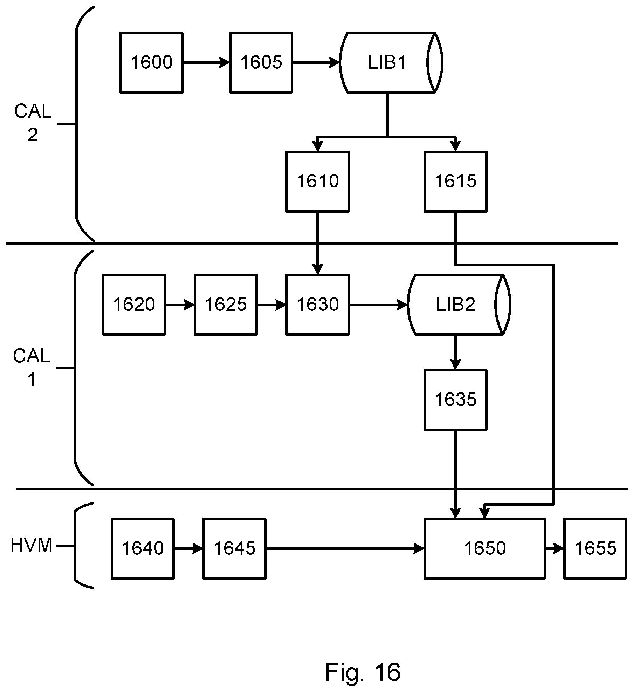

Figure 16 is a flowchart of a three-phase sequence to illustrate this concept. In this embodiment, there are two distinct calibration phases CAL1, CAL2. The first calibration phase CAL1 calibrates "mark-specific" effects and the second calibration phase CAL2 calibrates "non-mark specific" effects. The calibration for mark-specific effects may be performed separately for all different marks that are to be measured by the metrology sensor. A single calibration for non-mark specific effects can be used for different mark types. This is of course an example of implementation and different combinations of calibrations are possible.

In the second calibration phase CAL2 (e.g., for non-mark specific effects), at step 1600, first calibration data is acquired comprising one or multiple raw metrology signals for one or more marks. At step 1605, local phase and local amplitude distributions of the fringe pattern are extracted from each signal and compiled in a first correction library LIB 1. In the first calibration phase CAL1 (e.g., for mark specific effects), at step 1620, second calibration data is acquired comprising one or multiple raw metrology signals for one or more marks. At 1625, local phase and local amplitude distributions of the fringe pattern are extracted from the second calibration data. These distributions are corrected 1630 based on a retrieved (appropriate) local phase and/or local amplitude distribution from the first library LIB1 in retrieval step 1610. These corrected second calibration data distributions are stored in a second library LIB2 (this stores the correction parameter maps used in correcting product acquisition images).

In a production phase HVM or mark fitting phase, a signal is acquired 1640 from a mark (e.g., during production/IC manufacturing and the local phase and local amplitude distributions extracted 1645. The finite-size effects are corrected for 1650 based on a retrieval 1635 of an appropriate correction map from the second library LIB2 and (optionally) on a retrieval 1615 of an appropriate correction map from the first library LIB1. Note that step 1615 may replace steps 1610 and 1630 or these steps may be used in combination. Similarly, step 1615 may be omitted where steps 1610 and 1630 are performed. A position can then be determined in a further data analysis/processing step 1655.

Examples of non-mark-specific calibration information that might be obtained and used in such an embodiment include (non exhaustively):

- Period, orientation, amplitude, and/or visibility of the fringes;
- Position and magnitude of ghosts and other sources of unwanted light;
- Existence, magnitude, and shape of defects in the optics, cameras, apertures or in other relevant optical surfaces;
- Spot inhomogeneity and other sources of inhomogeneity in the spatial or angular distribution of light;
- Deformations of any kind (thermal, mechanical) of the sensor or any component;
- Aberrations in the optics and corresponding distortion induced on the acquired images, including both affine and non-affine deformations;
- Effect of defocus, shifts or in general movement in the 6 degrees of freedom.

All the contents of this disclosure (i.e., relating to blocks A, B and C) and all the previous embodiments may apply to each separate calibration phase.

In general, the library based methods described above show improved performance when the calibration correction data (e.g., correction library) or machine learning model is trained with the same sensor as will be used in the HVM phase, on the same type of marks at different positions with respect to the optical sensor within the expected (e.g.,

6DOF) range, and for different variables (e.g., *inter alia* stack types, sensor settings, location on the wafer). This may be repeated for different realizations to average out finite-size effects, and within-mark deformations, as it is necessary to remove the average fingerprint which repeats from mark-to-mark to enable determination of the unique deformation for each mark.

In general, multiple optical metrology sensors can benefit from such a database/library, provided that a position can be extracted from the signal with respect to the sensor. As such, library driven corrections may obtain good performance on the smallest possible mark types.

As has been described, in at least a calibration phase, training may be performed on representative wafers to create a calibration correction database or library via experiments and simulations. This library can then be rechecked or updated during HVM (e.g., in a shadow mode or validation mode).

It is proposed herein to train of the library and/or machine learning model based on inline data measured in a manufacturing phase (e.g., in HVM). In this manner, the correction library can be updated continuously during HVM using actual metrology target measurements. For every metrology target that is measured, or at least all those which meet at least one acceptance criterion such as a threshold fidelity on fit criteria, such as an expected signal pattern or signal strength, the library or model can be updated during HVM based on the measurement and/or correction derived therefrom. In this manner the correction library or model will become a better estimator for future target read-outs for e.g., the next wafers. For example, each individual target read-out can be used as an additional 'training' point to extend the correction library, thereby improving future corrections.

Such an approach will enable the database to ensemble average over many different target realizations. This will result in a better estimate of the unique within-mark imperfections of the measured mark, leading to a better sensor read out (e.g. aligned position or overlay measurements). Such an approach may also minimize time needed in the calibration phase or offline (e.g., validation) in an HVM phase. Additionally, more recently measured measurement data will tend to be more representative of present effects to be corrected than older data.

In an embodiment, such a method would enable the building of specific subset correction libraries or subset calibration correction data, which comprise one or more proper subsets of the correction library/calibration correction data. An example of such a subset correction library may be a correction library derived from only a previous group of lots (e.g., the last n lots processed, where n is any number). Another example may comprise only certain wafers from each lot, e.g., according to sequence order within a lot. For example, a subset correction library may comprise only the first wafer processed in each lot, first two (or more) wafers processed in each lot, last wafer (or last two or more wafers) processed in each lot etc..

Another grouping strategy which may form a basis for a subset correction library may relate to any context parameter within a wafer process flow that could affect the properties of the wafer prior to exposure. The previous layer is for example etched, polished, reworked, measured using a metrology tool, etc.. Each of these tools/steps will have context parameters that could be used for correlation, such as: a particular tool or combination of tools used to process the wafer such as etch chamber, deposition chamber etc.. Other context parameters may include, for example, in which batch a wafer is comprised for a particular process (e.g., which polishing batch was a wafer comprised) or what temperature was used to bake the resist. As such a subset correction library may relate only those wafers subject to a particular context.

It is also possible to monitor for changes in the correction library which may be indicative of changes in production and signaling potential yield loss.

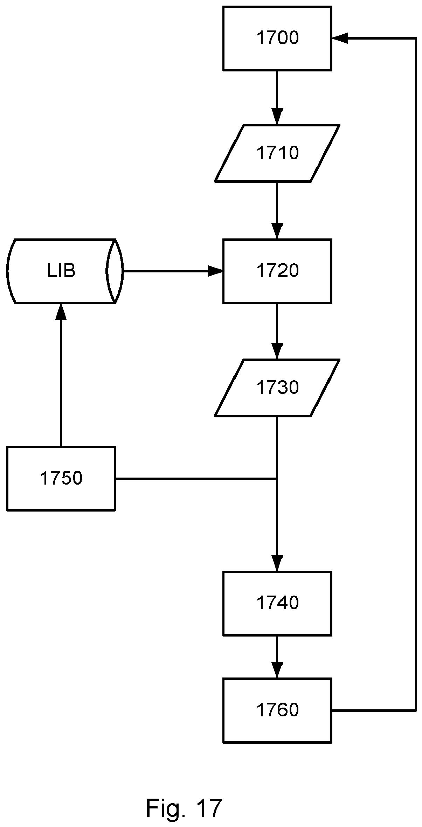

Figure 17 is a flowchart of the proposed method. At 1700, a measurement is made of a target. By way of specific example, this measurement may be an alignment measurement using an alignment sensor (e.g., an alignment sensor such as illustrated in Figure 3) to obtain a measured image 1710. A correction library LIB may be referenced in a fitting or correction step 1720 to obtain a corrected image 1730 which is corrected for at least finite mark effects and/or sensor effects. Step 1720 may use any of the library based methods already described. This corrected image 1730 can then be used to determine the parameter of interest 1740, e.g., an aligned position for the alignment target (or overlay value for an overlay target). The corrected image 1730 (and/or the corrected position) is then used to update/further train 1750 the correction library LIB (or model in a model based embodiment). The flow then continues to the next target 1760, where the flow repeats using the library LIB that has been updated with the previous correction.

It can be appreciated that the library approach disclosed herein may also be used for larger targets or very large targets (i.e., infinite sized with respect to the sensor). In such a case, finite size effects will not be relevant, but sensor effects due to sensor imperfections may still be corrected using the library approach disclosed herein, to enable access to the within-mark deformations. As such, the methods described herein are applicable to corrections of finite size effects and/or sensor effects.

In this manner, it is possible to reduce or minimize the training time required for building the training library or ML model. Also, as multiple realizations of the same mark are needed to ensemble average over within-mark variations in the training database, this method ensures that the training is continuously updated with such multiple realizations throughout HVM. Furthermore, this new training data is recent data which is more representative than older data. This will result in a better estimate of the unique within-mark imperfections, leading to a better sensor read out (e.g. aligned position or overlay measurements).

All the embodiments disclosed can apply to more standard dark-field or bright field metrology systems (i.e., other than an optimized coherence system as described in Figures 3 to 6). For example, in such more standard metrology device there may be ideal x (or y) fringes (e.g. half period of grating for x (or y) grating). Where LAPD is determined there may be an associated ripple. All corrections disclosed herein may be used to correct this ripple.

All embodiments disclosed can be applied to metrology systems which use fully spatially coherent illumination; these may be dark-field or bright-field systems, may have advanced illumination modes with multiple beams, and may have holographic detection modes that can measure the amplitude and phase of the detected field simultaneously.

All embodiments disclosed may be applied to metrology sensors in which a scan is performed over a mark, in which case the signal may e.g. consist of an intensity trace on a single-pixel photodetector. Such a metrology sensor may comprise a self-referencing interferometer, for example. In such an example, a database or library may be constructed and continuously updated of 6DOF dependent corrections (input scan direction + offset) on a line trace. A database driven correction method may become especially relevant for very small marks to mitigate edge effects, potential overlapping spot with surrounding structures and mark designs suffering from a scan offset.

While the above description may describe the proposed concept in terms of determining alignment corrections for alignment measurements, the concept may be applied to corrections for one or more other parameters of interest. For example, the parameter of interest may be overlay on small overlay targets (i.e., comprising two or more gratings in different layers), and the methods herein may be used to correct overlay measurements for finite-size effects. As such, any mention of position/alignment measurements on alignment marks may comprise overlay measurements on overlay targets.

While specific embodiments of the invention have been described above, it will be appreciated that the invention may be practiced otherwise than as described.

Any reference to a mark or target may refer to dedicated marks or targets formed for the specific purpose of metrology or any other structure (e.g., which comprises sufficient repetition or periodicity) which can be measured using techniques disclosed herein. Such targets may include product structure of sufficient periodicity such that alignment or overlay (for example) metrology may be performed thereon.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

**Claims**

1. A method for measuring a parameter of interest, comprising:

    obtaining measurement acquisition data relating to measurement of a target on a production substrate during a manufacturing phase;
    obtaining a calibration correction database and/or a trained model having been trained on said calibration correction database, operable to correct for effects in the measurement acquisition data;
    correcting for effects in the measurement acquisition data using first correction data from said calibration correction database and/or using said trained model so as to obtain corrected measurement data and/or a corrected parameter of interest which is/are corrected for at least said effects; and
    updating said calibration correction data and/or said trained model with said corrected measurement data and/or corrected parameter of interest.

**2.** A method as claimed in claim 1, wherein said effects in the measurement acquisition data comprise at least finite-size effects.

**3.** A method as claimed in claim 1 or 2, wherein said effects in the measurement acquisition data comprise at least sensor effects relating to the sensor optics used to acquire the measurement acquisition data.

**4.** A method as claimed in any preceding claim, wherein said updating step is performed for each target measured, or each target which satisfies at least one criterion.

**5.** A method as claimed in any preceding claim, wherein said updating step is performed as an inline update such that the updated calibration correction database and/or updated trained model is used for each subsequent measurement acquisition.

**6.** A method as claimed in any preceding claim, wherein said calibration correction database comprises different correction data for different target positions with respect to sensor optics used in measuring the target.

**7.** A method as claimed in any preceding claim, comprising building one or more subset calibration correction databases, each of which comprise one or more proper subsets of the calibration correction database.

**8.** A method as claimed in claim 7, wherein said correcting step uses first correction data from one of said one or more subset calibration correction databases appropriate for the measurement acquisition data.

**9.** A method as claimed in claim 7 or 8, wherein said one or more subset calibration correction databases comprises correction data from only a particular group of substrates and/or particular group of substrate lots.

**10.** A method as claimed in claim 9, wherein the particular group of substrates and/or particular group of substrate lots comprises one or more of the most recently processed substrates or substrate lots.

**11.** A method as claimed in claim 9, wherein the particular group of substrates and/or particular group of substrate lots comprises only the substrates each having one or more particular sequence numbers of a substrate lot.

**12.** A method as claimed in claim 11, wherein the particular group of substrates and/or particular group of substrate lots comprises only the first substrate of each substrate lot.

**13.** A method as claimed in claim 9, wherein the particular group of substrates and/or particular group of substrate lots comprises only the substrates relating to a particular context, said context relating to a processing history of the substrates.

**14.** A method as claimed in any preceding claim, wherein the measurement acquisition data comprises at least one acquisition local parameter distribution.

**15.** A method as claimed in claim 14, wherein said at least local parameter distribution comprises an acquisition local phase distribution.

**16.** A method as claimed in claim 14 or 15, wherein said at least local parameter distribution comprises an acquisition local amplitude distribution.

**17.** A method as claimed in any of claims 14 to 16, wherein the first correction data comprises at least one correction local parameter distribution.

**18.** A method as claimed in claim 17, wherein the at least one correction local parameter distribution comprises an error distribution describing only a deviation from a nominal local parameter distribution.

**19.** A method as claimed in claim 17 or 18, wherein the at least one correction local parameter distribution comprises one or both of a correction local phase distribution and correction local amplitude distribution.

**20.** A method as claimed in any of claims 17 to 19, wherein said calibration correction database comprises a plurality of correction local parameter distributions.

21. A method as claimed in claim 20, wherein said calibration correction database of correction local parameter distributions comprises different correction local parameter distributions for different target positions with respect to sensor optics used in measuring the target.

22. A method as claimed in claim 21, wherein said calibration correction database is indexed by an index parameter in accordance with said target positions.

23. A method as claimed in claim 22, wherein said calibration correction database is indexed by an index parameter, wherein said index parameter relates to one or more of: focus, global wafer coordinate, field coordinate, wafer orientation, lot number, lithographic tool used.

24. A method as claimed in any of claims 22 or 23, wherein a correction local parameter distribution is retrieved from the calibration correction database to be used in said correction step based on said index parameter.

25. A method as claimed in claim 24, wherein an acquisition index parameter is determined from the measurement acquisition data and/or other related data, and used to retrieve an appropriate correction local parameter distribution from the calibration correction database based on its associated index parameter.

26. A method as claimed in claim 25, wherein the acquisition index parameter is determined via a pre-fine alignment fit on said target.

27. A method as claimed in any of claims 20 to 26, wherein a correction local parameter distribution is retrieved from the calibration correction database by an optimality metric comparing the measurement acquisition data to the correction local parameter distributions.

28. A method as claimed in any of claims 20 to 27, wherein said trained model is used to map the measurement acquisition data to an appropriate correction local parameter distribution from the calibration correction database.

29. A method as claimed in any of claims 20 to 28, comprising a step of creating said calibration correction database in a calibration phase, said calibration phase comprising determining the correction local parameter distributions from calibration metrology data relating to one or more calibration targets on one or more calibration substrates.

30. A method as claimed in claim 29, wherein said calibration phase comprises multiple separate calibration phases, each calibrating for a separate effect or aspect of said effects.

31. A method as claimed in claim 30, wherein each calibration phase generates a separate calibration correction database.

32. A method as claimed in any of claims 14 to 31, wherein said at least one local parameter distribution and/or said at least one correction local parameter distribution is obtained by an extraction step which extracts said local parameter distribution from said measurement acquisition data and/or said at least one correction local parameter distribution from calibration measurement acquisition data.

33. A method as claimed in claim 32, wherein the extraction step comprises a pattern recognition step to determine one or more global quantities from the raw metrology signal.

34. A method as claimed in claim 33, wherein the local parameter distribution comprises a local amplitude distribution and said pattern recognition step comprises a registration of a target template position to the local amplitude distribution.

35. A method as claimed in any of claims 32 to 34, wherein said extraction step comprises an envelope fitting based on a set of raw metrology signals obtained from measurement of the same target with a measurement parameter varied.

36. A method as claimed in claim 35, wherein said envelope fitting comprises defining a signal model in terms of a set of basis functions and model parameters and minimizing a difference between the signal model and the set of set of raw metrology signals.

37. A method as claimed in claim 36, wherein the signal model further comprises additional parameters which describe local deviations of the signal due to non target-specific effects.

38. A method as claimed in any of claims 32 to 34, wherein said extraction step comprises a spatially weighted fit of a raw metrology signal comprised within said measurement acquisition data and/or said calibration measurement acquisition data.

39. A method as claimed in claim 38, wherein said spatially weighted fit comprises defining a set of basis functions to represent said raw metrology signal and minimizing, over the raw metrology signal, a spatially weighted cost function to determine coefficients for said basis functions.

40. A method as claimed in claim 38, wherein said spatially weighted fit comprises an approximate spatially weighted fit based on combining the raw metrology signal with a set of basis functions and convolving the resulting quantities with a kernel comprising a spatially localized function.

41. A method as claimed in any of claims 36, 37, 39 or 40 wherein said correcting step comprises reformulating said set of basis functions using said correction local parameter distribution; and using the reformulated basis functions to extract said one or more acquisition local parameter distributions thereby obtaining said corrected measurement data.

42. A method as claimed in any of claims 17 to 41, wherein said correcting step comprises subtracting said correction local parameter distribution from said acquisition local parameter distribution to obtain said corrected measurement data.

43. A method as claimed in any of claims 33 to 37, wherein said correction step comprises fitting the acquisition local parameter distribution using a model based on said at least one correction local parameter distribution which comprises a correction local amplitude distribution, a correction local phase distribution and a correction DC distribution, to obtain said corrected measurement data.

44. A method as claimed in any preceding claim, wherein said correcting step comprises:

using the first correction data and/or trained model to obtain said corrected measurement data; and
using the corrected measurement data to determine the parameter of interest.

45. A method as claimed in any of claims 1 to 19, comprising applying said trained model to said measurement acquisition data to directly determine said parameter of interest.

46. A method as claimed in claim 44, comprising applying said trained model to said measurement acquisition data to determine said corrected measurement data.

47. A method as claimed claim 45 or 46, wherein the trained model is a machine learning model.

48. A method as claimed in claim 47, comprising training said model using labeled calibration data in said calibration correction database relating to one or more calibration targets on one or more calibration substrates.

49. A method as claimed in any preceding claim, wherein the parameter of interest is aligned position.

50. A method as claimed in any of claims 1 to 49, wherein the parameter of interest is overlay or focus.

51. A computer program comprising program instructions operable to perform the method of any preceding claim, when run on a suitable apparatus.

52. A non-transient computer program carrier comprising the computer program of claim 51.

53. A processing arrangement comprising:

the non-transient computer program carrier of claim 52; and
a processor operable to run said computer program.

**54.** A metrology device comprising the processing arrangement of claim 53.

**55.** A lithographic apparatus comprises the metrology device of claim 54.

**56.** A lithographic apparatus comprising:

a patterning device support for supporting a patterning device;
a substrate support for supporting a substrate; and
a metrology device being operable to perform the method of claim 49.

**57.** A lithographic as claimed in claim 56, being operable to use said aligned position value in control for one or both of:

said substrate support and/or a substrate supported thereon, and
said patterning device support and/or a patterning device supported thereon.

Fig. 1

Fig. 2

Fig. 3

Fig. 4

Fig. 5

(a)

500

510

500'

510

(b)

Fig. 6

| 700 | → | 710 | → | 720 | → | 730 |

Fig. 7

| 800 | → | 810 | → | 820 | → | 830 |

Fig. 8

CAL

BL A | 900 | → | 910 | → | BL B | 920 |
920 → 950

HVM | 930 | → | 940 | → | 960 | → | 970 |
BL C

Fig. 9

Fig. 10

Fig. 11

LPM

IM → 1200 → LAM → 1210 → NCC → 1220

MT → 1210

1220 → POS

Fig. 12

CAL

CLPM

HVM — 1300 → LAPD → 1310 → LAPD' → 1320 → POS

IM → 1300

Fig. 13

Fig. 14

Fig. 15

Fig. 16

Fig. 17

Europäisches
Patentamt

European
Patent Office

Office européen
des brevets

# EUROPEAN SEARCH REPORT

Application Number

EP 21 19 9332

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "METHOD OF METROLOGY AND ASSOCIATED APPARATUSES", RESEARCH DISCLOSURE, KENNETH MASON PUBLICATIONS, HAMPSHIRE, UK, GB, vol. 682, no. 2, 1 June 2021 (2021-06-01), XP007149067, ISSN: 0374-4353 [retrieved on 2020-12-23] | 1-6 | INV. G03F7/20 G03F9/00 |
| A | * paragraphs [0005], [0006], [0059] - [0061], [0071] * | 7-13,15 | |
| X | EP 1 517 189 A2 (ASML NETHERLANDS BV [NL]) 23 March 2005 (2005-03-23) * paragraphs [0019], [0042] - [0047]; figure 2 * | 1,5,14 | |

TECHNICAL FIELDS SEARCHED (IPC)

G03F

The present search report has been drawn up for all claims

| Place of search | Date of completion of the search | Examiner |
|---|---|---|
| Munich | 13 June 2022 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

EP 21 19 9332

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

[X] No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

## ANNEX TO THE EUROPEAN SEARCH REPORT
## ON EUROPEAN PATENT APPLICATION NO.

EP 21 19 9332

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2022

| Patent document cited in search report | | Publication date | Patent family member(s) | | Publication date |
|---|---|---|---|---|---|
| EP 1517189 | A2 | 23-03-2005 | CN | 1629729 A | 22-06-2005 |
| | | | EP | 1517189 A2 | 23-03-2005 |
| | | | JP | 4262175 B2 | 13-05-2009 |
| | | | JP | 2005094015 A | 07-04-2005 |
| | | | KR | 20050028800 A | 23-03-2005 |
| | | | SG | 110201 A1 | 28-04-2005 |
| | | | TW | I245976 B | 21-12-2005 |
| | | | US | 2005075819 A1 | 07-04-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- WO 2020057900 A1
- WO 2020057900 A